# EUROPEAN PATENT SPECIFICATION

(11) **EP 4 169 998 B1**
(45) Date of publication and mention of the grant of the patent: **17.12.2025**
(21) Application number: 22201247.8
(22) Date of filing: 13.10.2022
(51) Int. Cl.: C09K 5/14, C08J 3/20, C08K 3/28, C08L 83/04, H01L 23/373

(54) **THERMAL CONDUCTIVE SILICONE COMPOSITION**
WÄRMELEITFÄHIGE SILIKONZUSAMMENSETZUNG
COMPOSITION DE SILICONE THERMOCONDUCTRICE

(30) Priority: 21.10.2021 JP 2021172352
(43) Date of publication of application: 26.04.2023
(73) Proprietor: SHIN-ETSU CHEMICAL CO., LTD., Tokyo 1000005 (JP)
(72) Inventor: Toya, Wataru, Gunma (JP)
(74) Representative: Sonnenhauser, Thomas Martin

(56) References cited:
- US-A1- 2018 134 938
- US-A1- 2019 292 349
- US-A1- 2021 017 437

## Description

### TECHNICAL FIELD

The present invention relates to a thermal conductive silicone composition.

### BACKGROUND ART

It is widely known that semiconductor elements generate heat in use, thereby lowering the performances thereof, and various heat dissipation techniques have been used as a means to solve this problem. Typical heat dissipation techniques include a technique involving disposing a cooling member (such as a heat sink) near a heat-generating part and bringing them into close contact to efficiently remove and dissipate heat from the cooling member. In this event, if there is a space between the heat-generating member and the cooling member, thermal conductivity is lowered because of the presence of air, which is poor in thermal conduction property, so that the temperature of the heat-generating member cannot be reduced sufficiently. To prevent this phenomenon, heat dissipation materials with good thermal conductivity and followability to the surface of the member, such as heat-dissipating grease or heat-dissipating sheets, have been used.

In recent years, the amount of heat generation during the operation is further increasing for semiconductors of high-grade devices, such as CPUs for servers, IGBTs for driving vehicles, and the like. As the amount of heat generation increases, the heat dissipation performance required for heat-dissipating grease and heat-dissipating sheets has also increased. Heat-dissipating grease is useful as a heat dissipation material for such semiconductor elements because it has low contact thermal resistance. On the other hand, in some cases, when the viscosity of the heat-dissipating grease is lowered in order to ensure desirable coating performance, the heat-dissipating grease slips off due to the thermal shock of the element or vibration from outside; as a result, the heat dissipation cannot be sufficiently performed, and results in breakage of the element.

Patent Document 1 proposes a high thermal conductive grease that ensures both shift resistance and coating performance by containing both a metal oxide and a metal nitride in combination. However, Patent Document 1 nowhere discloses those having a thermal conductivity of 7.5 W/m·K or more, and thus cannot ensure sufficient heat dissipation performance. On the other hand, Patent Documents 2 and 3 achieved low viscosity and high thermal conductivity of 7.5 W/m·K or more by incorporating an insulating inorganic filler at a specific ratio in order to improve the discharge performance of the heat-dissipating grease. However, because of its high flowability, the shift resistance was insufficient.

Patent Document 4 discloses thermally conductive silicone compositions having an organopolysiloxane as a base polymer and containing a thermally conductive filler. They can be used as heat-dissipating members which have excellent thermal conductivity and water resistance, and moreover also have good adherence during packaging.

Patent Document 5 discloses a thermally conductive composition including a matrix resin, a curing catalyst, and thermally conductive particles. The composition is suitable for being interposed between a heat generating part and a heat dissipater of an electrical component, an electronic component or the like, and a thermally conductive sheet using the thermally conductive composition.

Patent Document 6 discloses a thermally conductive composition good in thermal conductivity, low in viscosity and easy in application. The composition includes (A) a spherical thermally conductive filler and (B) an alkoxysilane compound or dimethylpolysiloxane.

### CITATION LIST

### PATENT LITERATURE

Patent Document 1: JP 2020-063365 A
Patent Document 2: JP 6246986 B
Patent Document 3: WO 2020/262449 A1
Patent Document 4: US 2019/292349 A1
Patent Document 5: US 2021/017437 A1
Patent Document 6: US 2018/134938 A1

### SUMMARY OF INVENTION

### TECHNICAL PROBLEM

The present invention was accomplished in light of the circumstances described above, and an object of the present invention is to provide a thermal conductive silicone composition that ensures both high thermal conductivity and shift resistance.

### SOLUTION TO PROBLEM

In order to achieve the above object, the present invention provides a thermal conductive silicone composition comprising:
(C) one or more aluminum nitride particles selected from an irregular-shaped, a round, and a polyhedral particles having an average particle size of 4 µm or more and 30 µm or less;
(D) one or more aluminum nitride particles selected from an irregular-shaped, a round, and a polyhedral particles having an average particle size of 60 µm or more and 150 µm or less;
   and
(E) an irregular-shaped zinc oxide particle having an average particle size of 0.1 µm or more and less than 4.0 µm;
   wherein
   a total amount of the component (C) and the component (D) is 20 mass% or more and less than 80 mass% in the entire composition, and
   an amount of the component (E) is 20 mass% or more and less than 50 mass% in the entire composition, a ratio of the component (D) relative to the total amount of the component (C) and the component (D) is 5 mass% or more and less than 50 mass%,
   wherein the term "round particles" means that the particles have less corners and are rounded and smooth, and a spherical shape is not included.

This thermal conductive silicone composition ensures both high thermal conductivity and shift resistance.

Further, in the present invention, the component (C) are preferably round aluminum nitride particles.

Such a component (C) makes it possible to impart further higher thermal conductivity to the thermal conductive silicone composition.

Further, in the present invention, the component (C) is preferably such that, when a paste with a thickness of 300 µm prepared by mixing 150 parts by mass of the component (C) and 100 parts by mass of a dimethylpolysiloxane having a kinematic viscosity at 25°C of 1,000 mm²/s is pressurized at 25°C and 0.1 MPa for 60 minutes, the thickness of the pressurized silicone composition is 10 µm or more and 100 µm or less.

Within this range, it is possible to decrease the viscosity of the thermal conductive silicone composition, thereby further improving the workability.

Herein, the component (E) is an irregular-shaped zinc oxide particle.

With such an inorganic particle, the thermal conductivity and the shift resistance of the thermal conductive silicone composition can be further more improved.

The present invention preferably further comprises (A) an organopolysiloxane having a kinematic viscosity at 25°C of 10 to 100,000 mm²/s.

When the viscosity of the component (A) is within a predetermined range, the bleeding out of the organopolysiloxane from the thermal conductive silicone composition can be suppressed, and the thermal conductive silicone composition has further superior extensibility.

Herein, the component (A) is preferably an organopolysiloxane having one or more aliphatic unsaturated hydrocarbon groups bonded to a silicon atom within one molecule.

As the component (A) used in the present invention, the above-described component is preferable.

Further, herein,
(F) an organohydrogenpolysiloxane having two or more hydrogen atoms bonded to a silicon atom within one molecule;
(G) a platinum group metal catalyst;
   and
(H) a reaction inhibitor
are preferably contained.

By incorporating these components, an addition reaction type thermal conductive silicone composition can be obtained, thereby further improving the shift resistance.

Further, herein, a hydrosilylation reaction product of the component (A) and the component (F) is preferably contained.

By incorporating such a component, the shift resistance can be further improved.

Further, in the present invention, a number of the hydrogen atoms bonded to a silicon atom within one molecule in the component (F) is preferably 4.0 to 20.0 relative to one aliphatic unsaturated hydrocarbon group bonded to a silicon atom within one molecule in the component (A).

Within this range, it is possible to further improve the shift resistance of the thermal conductive silicone composition.

Further, the present invention preferably comprises (I) an organic peroxide.

By incorporating such a component (I), the shift resistance of the thermal conductive silicone composition can be further improved due to the radical reaction between the components (A).

Further, the present invention preferably further comprises (B) a hydrolysable organopolysiloxane containing an alkoxysilyl group.

With this component, the flowability during filling with the component (C), the component (D), and the component (E) can be improved.

Herein, (J) a condensation catalyst is preferably further contained.

By incorporating such a component (J), the shift resistance of the thermal conductive silicone composition can be further improved by the condensation reaction of the component (B).

### ADVANTAGEOUS EFFECTS OF INVENTION

The present invention makes it possible to obtain a thermal conductive silicone composition having high thermal conductivity and superior shift resistance.

### DESCRIPTION OF EMBODIMENTS

As described above, development of a thermal conductive silicone composition ensuring both high thermal conductivity and shift resistance has been in demand.

The inventors of the present invention conducted extensive research to achieve the above object, and consequently found that a thermal conductive silicone composition comprising an aluminum nitride particle having a specific particle size and a shape and an irregular-shaped zinc oxide particle has high thermal conductivity and superior shift resistance. With this finding, the inventors completed the present invention.

Specifically, the present invention is a thermal conductive silicone composition, comprising:
(C) one or more aluminum nitride particles selected from an irregular-shaped, a round, and a polyhedral particles having an average particle size of 4 µm or more and 30 µm or less;
(D) one or more aluminum nitride particles selected from an irregular-shaped, a round, and a polyhedral particles having an average particle size of 60 µm or more and 150 µm or less;
   and
(E) an irregular-shaped zinc oxide particle having an average particle size of 0.1 µm or more and less than 4.0 µm;
   wherein
   a total amount of the component (C) and the component (D) is 20 mass% or more and less than 80 mass% in the entire composition, and
   an amount of the component (E) is 20 mass% or more and less than 50 mass% in the entire composition, a ratio of the component (D) relative to the total amount of the component (C) and the component (D) is 5 mass% or more and less than 50 mass%,
   wherein the term "round particles" means that the particles have less corners and are rounded and smooth, and a spherical shape is not included.

The present invention is described below in detail; however, the present invention is not limited to the examples described below.

### [Thermal Conductive Silicone Composition]

The thermal conductive silicone composition of the present invention comprises (C) one or more aluminum nitride particles selected from an irregular-shaped, a round, and a polyhedral particles having an average particle size of 4 µm or more and 30 µm or less; (D) one or more aluminum nitride particles selected from an irregular-shaped, a round, and a polyhedral particles having an average particle size of 60 µm or more and 150 µm or less; and (E) an irregular-shaped zinc oxide particle having an average particle size of 0.1 µm or more and less than 4.0 µm; wherein a total amount of the component (C) and the component (D) is 20 mass% or more and less than 80 mass% in the entire composition, and an amount of the component (E) is 20 mass% or more and less than 50 mass% in the entire composition, a ratio of the component (D) relative to the total amount of the component (C) and the component (D) is 5 mass% or more and less than 50 mass%, wherein the term "round particles" means that the particles have less corners and are rounded and smooth, and a spherical shape is not included. The thermal conductive silicone composition of the present invention may contain the components (A), (B), (F) to (J) and other components described later. Hereinbelow, each component is described.

### [Component (C)]

The component (C) is one or more aluminum nitride particles selected from an irregular-shaped, a round, and a polyhedral particles having an average particle size of 4 µm or more and 30 µm or less. The shape of the component (C) is preferably round, and the round shape herein means that the particles have less corners and are rounded and smooth, and the spherical shape is not included. The round shape is clearly different from the spherical shape in that it has corners. Spherical aluminum nitride is not preferable because it is inferior in thermal conduction property.

If the average particle size of the component (C) is smaller than 4 µm, the thermal conductivity of the thermal conductive silicone decreases. If the average particle size of the component (C) is 50 µm or more, the resulting silicone composition may not be uniform. In the present invention, the average particle size is a cumulative average diameter D₅₀ (median diameter) in the particle size distribution on volumetric basis according to the laser diffraction and scattering method, and can be measured by, for example, Microtrac MT3300EX manufactured by Nikkiso Co., Ltd.

The aluminum nitride particles of the component (C) and the component (D) described later can be synthesized by the known direct nitridation method, reduction nitridation method or the like, and can be formed into an arbitrary particle size range by way of pulverization or the like. In addition, the round aluminum nitride particles can be obtained by heat-treating irregular-shaped or polyhedral aluminum nitride in a non-oxidizing atmosphere at 1,600°C to 2,000°C.

The component (C) is preferably such that, when a paste with a thickness of 300 µm prepared by mixing 150 parts by mass of the component (C) and 100 parts by mass of a dimethylpolysiloxane having a kinematic viscosity at 25°C of 1,000 mm²/s is pressurized at 25°C and 0.1 MPa for 60 minutes, the thickness of the pressurized silicone composition is 10 µm or more and 100 µm or less, more preferably 10 µm or more and 50 µm or less. With the component (C) within this range, it is possible to decrease the viscosity of the thermal conductive silicone composition, thereby further improving the workability.

The component (C) may be one kind or in a combination of two or more kinds.

### [Component (D)]

The component (D) is one or more aluminum nitride particles selected from an irregular-shaped, a round, and a polyhedral particles having an average particle size of 60 µm or more and 150 µm or less, preferably 60 µm or more and 120 µm or less, more preferably 70 µm or more and 120 µm or less. Spherical aluminum nitride is not preferable because it is inferior in thermal conduction property.

When the average particle size of the component (D) is less than 50 µm, the thermal conductivity of the obtained thermal conductive silicone composition decreases. When the average particle size of the component (D) is more than 150 µm, the obtained thermal conductive silicone composition tends to be non-uniform.

The component (D) may be one kind or in a combination of two or more kinds.

The total amount of the component (C) and the component (D) is 20 mass% or more and less than 80 mass% in the entire composition, and is preferably 50 mass% to less than 80 mass%. When the total amount of the component (C) and the component (D) is less than 20 mass%, the thermal conductivity of the obtained thermal conductive silicone composition decreases. If the total amount of the component (C) and the component (D) is 80 mass% or more, the thermal conductive silicone composition will not be uniform.

In addition, the ratio of the component (D) relative to the total amount of the component (C) and the component (D) is 5 mass% or more and less than 50 mass%. If the ratio of the component (D) is less than 5 mass%, the thermal conductivity of the thermal conductive silicone composition will be inferior, and if the ratio of the component (D) is 50 mass% or more, the shift resistance of the thermal conductive silicone composition will be inferior.

### [Component (E)]

The component (E) is an irregular-shaped zinc oxide particle having an average particle size of 0.1 µm or more and less than 4.0 µm, preferably 0.4 µm or more and 2.0 µm or less. If the average particle size is less than 0.1 µm, the viscosity of the thermal conductive silicone composition increases and the handleability decreases. If the average particle size is 4.0 µm or more, the thermal conductive silicone composition will not be uniform.

The amount of the component (E) is preferably 20 mass% or more and less than 50 mass%, preferably 25 to 40 mass% in the entire thermal conductive silicone composition. If the component (E) is less than 20 mass%, the thermal conductive silicone composition will not be uniform. If the component (E) is 50 mass% or more, the viscosity of the thermal conductive silicone composition increases and the handleability decreases.

The component (E) may be one kind or in a combination of two or more kinds.

### [Component (A)]

The thermal conductive silicone composition of the present invention preferably comprises (A) an organopolysiloxane having a kinematic viscosity at 25°C of 10 to 100,000 mm²/s, preferably 30 to 10,000 mm²/s, and further preferably 100 to 8,000 mm²/s. When the viscosity is within a predetermined range, the bleeding out of the organopolysiloxane from the thermal conductive silicone composition can be suppressed, and the thermal conductive silicone composition has further superior extensibility. In the present invention, the kinematic viscosity refers to a value measured at 25°C using an Ostwald viscometer.

The molecular structure of the organopolysiloxane as component (A) is not particularly limited and may be linear, branched, cyclic, or the like. In particular, it is preferable to have a linear structure in which the main chain is composed of repeating diorganosiloxane units and both terminals of the molecular chain are blocked with triorganosiloxy groups. The organopolysiloxane may be one kind or in a combination of two or more kinds.

The organopolysiloxane may be represented by the following average composition formula (1).

R¹ₐSiO_{(4-a)/2} (1)

In the average composition formula (1), R¹ independently represents a saturated or unsaturated, unsubstituted or substituted monovalent hydrocarbon group having 1 to 18, preferably 1 to 14 carbon atoms. Examples of the monovalent hydrocarbon group include alkyl groups such as a methyl group, an ethyl group, a propyl group, a hexyl group, an octyl group, a decyl group, a dodecyl group, a tetradecyl group, a hexadecyl group, and an octadecyl group; cycloalkyl groups such as a cyclopentyl group and a cyclohexyl group; alkenyl groups such as a vinyl group and an allyl group; aryl groups such as a phenyl group and a tolyl group; aralkyl groups such as a 2-phenylethyl group and a 2-methyl-2-phenylethyl group; as well as these groups in which a part or all of the hydrogen atoms are substituted with a halogen atom such as fluorine, bromine, and chlorine, a cyano group or the like, for example, a 3,3,3-trifluoropropyl group, a 2-(perfluorobutyl) ethyl group, a 2-(perfluorooctyl) ethyl group, and a p-chlorophenyl group. Among them, a methyl group, a phenyl group and a vinyl group are preferable.

In the average composition formula (1) above, "a" is a number in the range of 1.8 to 2.2, in particular, in the range of 1.9 to 2.1. When "a" is within the above range, the thermal conductive silicone composition to be obtained may have a desirable viscosity.

The organopolysiloxane represented by the average composition formula (1) is preferably a linear organopolysiloxane represented by the following formula (2).

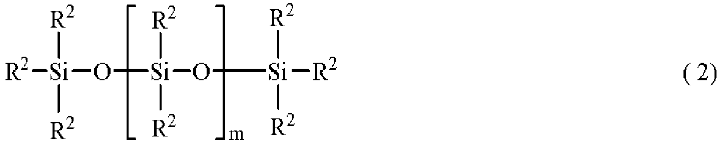

In the formula (2) above, R² independently represents a saturated or unsaturated, unsubstituted or substituted monovalent hydrocarbon group having 1 to 18, preferably 1 to 14 carbon atoms. Examples of the monovalent hydrocarbon group include the groups mentioned above. Further, it is preferable that at least one R² is a vinyl group. "m" is a number with which the organopolysiloxane has a kinematic viscosity at 25°C of 10 to 100,000 mm²/s, preferably 30 to 10,000 mm²/s, more preferably 100 to 8,000 mm²/s.

The amount of the component (A) is preferably 0.1 to 60 mass%, more preferably 0.1 to 10 mass%, in the entire composition. Only one kind, or a combination of two or more kinds of the component (A) may be contained.

Further, the component (A) is preferably an organopolysiloxane having one or more aliphatic unsaturated hydrocarbon groups bonded to a silicon atom within one molecule.

### [Component (B)]

The component (B) is a hydrolysable organopolysiloxane containing an alkoxysilyl group. The component (B) acts as a surface treatment agent for the components (C) to (E) above. Therefore, by adding the component (B), the thermal conductive silicone composition maintains its flowability even when the composition contains a large amount of the components (C) to (E). It is also possible to suppress a decrease in heat dissipation performance due to oil separation or pumping out over time. Examples of the component (B) include organopolysiloxanes represented by the following general formula (3). In particular, it is preferable to contain a trifunctional hydrolysable organopolysiloxane.

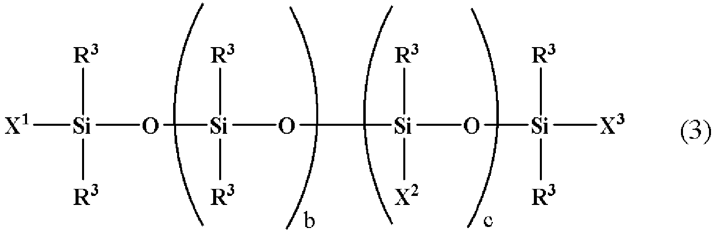

In the formula, R³ independently represents an unsubstituted or substituted monovalent hydrocarbon group. X¹, X², and X³ may be the same or different, and each represent a group represented by R³ or -(R⁴)ₙ-SiR⁵_{d}(OR⁶)_{3-d}, given that at least one of X¹, X², and X³ is a group represented by -(R⁴)ₙ-SiR⁵_{d}(OR⁶)_{3-d}. R⁴ is an oxygen atom or an alkylene group having 1 to 4 carbon atoms, R⁵ independently represents an unsubstituted or substituted monovalent hydrocarbon group containing no aliphatic unsaturated bonds, R⁶ independently represents an alkyl group, an alkoxyalkyl group, an alkenyl group or an acyl group each having 1 to 4 carbon atoms, "n" is 0 or 1, "d" is an integer of 0 to 2. "b" and "c" satisfy 1≤b≤1,000 and 0≤c≤1,000, respectively.

In the above general formula (3), R³ independently represents an unsubstituted or substituted monovalent hydrocarbon group having preferably 1 to 10, more preferably 1 to 6, further preferably 1 to 3 carbon atoms. Examples thereof include a linear alkyl group, a branched alkyl group, a cyclic alkyl group, an alkenyl group, an aryl group, an aralkyl group, a halogenated alkyl group, and the like. Examples of the linear alkyl group include a methyl group, an ethyl group, a propyl group, a hexyl group, and an octyl group. Examples of the branched alkyl group include an isopropyl group, an isobutyl group, a tert-butyl group, and a 2-ethylhexyl group. Examples of the cyclic alkyl group include a cyclopentyl group and a cyclohexyl group. Examples of the alkenyl group include a vinyl group and an allyl group. Examples of the aryl group include a phenyl group and a tolyl group. Examples of the aralkyl group include a 2-phenylethyl group and a 2-methyl-2-phenylethyl group. Examples of the halogenated alkyl group include a 3,3,3-trifluoropropyl group, a 2-(nonafluorobutyl) ethyl group, and a 2-(heptadecafluorooctyl)ethyl group. R³ is preferably a methyl group, a phenyl group or a vinyl group.

X¹, X², and X³ may be the same or different, and each represent a group represented by R³ or -(R⁴)ₙ-SiR⁵_{d}(OR⁶)_{3-d}, given that at least one of X¹, X², and X³ is a group represented by -(R⁴)ₙ-SiR⁵_{d}(OR⁶)_{3-d}.

R⁴ is an oxygen atom or an alkylene group having 1 to 4 carbon atoms, and examples of the alkylene group having 1 to 4 carbon atoms represented by R⁴ include a methylene group, an ethylene group, a propylene group, a butylene group, and the like. R⁵ independently represents an unsubstituted or substituted monovalent hydrocarbon group that has preferably 1 to 10, more preferably 1 to 6, further preferably 1 to 3 carbon atoms, and that does not contain aliphatic unsaturated bonds. Examples thereof include alkyl groups such as a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group, and a dodecyl group; cycloalkyl groups such as a cyclopentyl group, a cyclohexyl group, and a cycloheptyl group; aryl groups such as a phenyl group, a tolyl group, a xylyl group, a naphthyl group, and a biphenylyl group; aralkyl groups such as a benzyl group, a phenylethyl group, a phenylpropyl group, and a methylbenzyl group; as well as these groups in which a part or all of the hydrogen atoms bonded to a carbon atom(s) are substituted with a halogen atom such as fluorine, chlorine, and bromine, a cyano group, or the like.

The above R⁶ independently represents an alkyl group, an alkoxyalkyl group, an alkenyl group, or an acyl group each having 1 to 4 carbon atoms. Examples of the alkyl group represented by R⁶ include the same alkyl groups having 1 to 4 carbon atoms as those exemplified as R³, and the like. Examples of the alkoxyalkyl group include a methoxyethyl group, a methoxypropyl group, and the like. Examples of the alkenyl group include a vinyl group and an allyl group. Preferable Examples of the acyl group represented by the above R⁶ include those having 2 to 8 carbon atoms, such as an acetyl group, an octanoyl group, and the like. R⁶ is preferably an alkyl group, and particularly preferably a methyl group or an ethyl group.

"b" and "c" are 1≦b≦1,000 and 0≦c≦1,000, respectively; however, it is preferable that b+c is 10 to 1,000, more preferably 10 to 300. n is 0 or 1, and d is an integer of 0 to 2, preferably 0. In addition, it is preferable that 1 to 6, particularly preferably 3 or 6 OR⁶ groups are present in the molecule. The order of bonding of the siloxane units in the parentheses is not limited to that described below.

Preferable specific examples of the component (B) include the following.

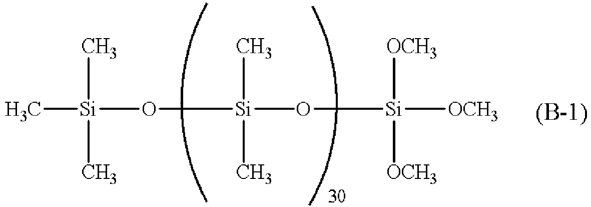

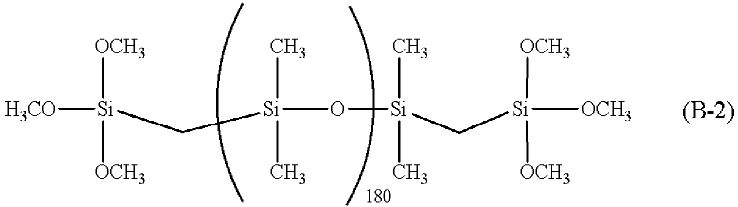

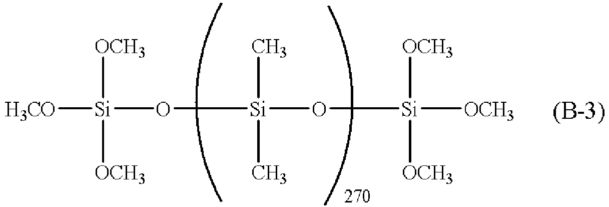

The amount of the component (B) is preferably 0.1 to 60 mass%, more preferably 1 to 10 mass%, in the entire composition. Only one kind, or a combination of two or more kinds of the component (B) may be contained.

In the thermal conductive silicone composition of the present invention, if the component (A) is the organopolysiloxane having one or more aliphatic unsaturated hydrocarbon groups bonded to a silicon atom within one molecule, it is possible to obtain an addition reaction type thermal conductive silicone composition by further adding the following components (F) to (H).

### [Component (F)]

The component (F) is an organohydrogenpolysiloxane having two or more, preferably three or more and less than 40 hydrogen atoms bonded to silicon atoms (SiH groups) in one molecule, that is, an organohydrogenpolysiloxane having two or more hydrogen atoms bonded to silicon atoms in one molecule. The hydrogen atoms bonded to silicon atoms in the molecule undergo an addition reaction with aliphatic unsaturated hydrocarbon groups in the composition in the presence of a platinum group metal catalyst, which is described later, thereby forming a crosslinked structure.

There are no particular limitations on the molecular structure of the component (F), and the component (F) may have a linear, branched, or cyclic molecular structure, including those represented by the average composition formula (4) shown below.

R⁷ₑH_{f}SiO_{(4-e-f)/2} (4)

In the average composition formula (4), R⁷ independently represents a saturated or unsaturated, unsubstituted or substituted monovalent hydrocarbon group having 1 to 18, preferably 1 to 14 carbon atoms, excluding aliphatic hydrocarbon groups. Examples of the monovalent hydrocarbon group include alkyl groups such as a methyl group, an ethyl group, a propyl group, a hexyl group, an octyl group, a decyl group, a dodecyl group, a tetradecyl group, a hexadecyl group, and an octadecyl group; cycloalkyl groups such as a cyclopentyl group and a cyclohexyl group; alkenyl groups such as a vinyl group and an allyl group; aryl groups such as a phenyl group and a tolyl group; aralkyl groups such as a 2-phenylethyl group and a 2-methyl-2-phenylethyl group; as well as these groups in which a part or all of the hydrogen atoms are substituted with a halogen atom such as fluorine, bromine, and chlorine, a cyano group or the like, for example, a 3,3,3-trifluoropropyl group, a 2-(perfluorobutyl) ethyl group, a 2-(perfluorooctyl) ethyl group, and a p-chlorophenyl group. R⁷ is particularly preferably a methyl group or a phenyl group.

"e" is a positive number of 1.0 to 3.0, preferably 0.5 to 2.5, "f" is a positive number of 0.005 to 2.0, preferably 0.01 to 1.0, and e+f is a positive number satisfying a range of 0.5 to 3.0, preferably 0.8 to 2.5.

The amount of the component (F) is such that the number of the hydrogen atoms bonded to silicon atoms within one molecule in the component (F) is preferably 4.0 to 20.0, more preferably 8.0 to 20.0, relative to one aliphatic unsaturated hydrocarbon group bonded to a silicon atom within one molecule in the component (A). This range ensures further preferable shift resistance. Only one kind, or a combination of two or more kinds of the component (F) may be contained.

Further, the present invention preferably contains a hydrosilylation reaction product of the component (A) and the component (F). By incorporating such a component, the shift resistance can be further improved.

### [Component (G)]

The component (G) is a platinum group metal catalyst to be used to promote the hydrosilylation reaction between the aliphatic unsaturated hydrocarbon group bonded to a silicon atom in the component (A) and the SiH group in the component (F). The platinum group metal catalyst may be a previously-known platinum group metal catalyst for use in addition reaction. Examples include platinum-based catalysts, palladium-based catalysts, and rhodium-based catalysts. Among them, platinum or platinum compounds, which can be relatively easily obtained, are preferred. Examples thereof include elemental platinum, platinum black, chloroplatinic acid, a platinum-olefin complex, a platinum-alcohol complex, a platinum coordination compound, and the like.

The amount of the component (G) is preferably in a range of 1 to 2,000 ppm, more preferably 2 to 1,000 ppm in terms of the mass of platinum group metal atoms relative to the organopolysiloxane, i.e., the component (A). By setting the amount within this range, the addition reaction is advanced at an appropriate reaction rate.

Only one kind, or a combination of two or more kinds of the component (G) may be used.

### [Component (H)]

The component (H) is a reaction inhibitor that suppresses the progress of the hydrosilylation reaction at room temperature, and functions to extend shelf life and pot life. As the reaction inhibitor, a previously-known reaction inhibitor used for addition curing silicone compositions may be used. Examples thereof include acetylene compounds such as acetylene alcohols (e.g. ethynylmethyldecylcarbinol, 1-ethynyl-1-cyclohexanol, and 3,5-dimethyl-1-hexyn-3-ol); various nitrogen compounds such as tributylamine, tetramethylethylenediamine, and benzotriazole; organophosphorus compounds such as triphenylphosphine; oxime compounds; organic chloro compounds; and the like.

### [Component (I)]

In the thermal conductive silicone composition of the present invention, if the component (A) is the organopolysiloxane having one or more aliphatic unsaturated hydrocarbon groups bonded to a silicon atom within one molecule, it is possible to further enhance the shift resistance of the composition by the radical reaction between the components (A) by adding (I) an organic peroxide.

The organic peroxide may be a previously-known organic peroxide for use in radical reaction. Examples of the organic peroxide include acyl organic peroxides such as benzoyl peroxide, bis(p-methylbenzoyl) peroxide; alkyl organic peroxides such as di-tert-butyl peroxide, 2,5-dimethyl-2,5-di(tert-butylperoxy)hexane, tert- butylcumyl peroxide and dicumyl peroxide; and ester organic peroxides such as tert-butylperbenzoate.

### [Component (J)]

When the thermal conductive silicone composition of the present invention contains the component (B) described above, a condensation reaction type thermal conductive silicone composition may be obtained by further adding (J) a condensation catalyst. The condensation reaction of the component (B) further enhances the shift resistance of the thermal conductive silicone composition.

The condensation catalyst may be a previously-known condensation catalyst for use in condensation reaction. Examples include metal-based catalysts, including titanium esters such as tetrabutyl titanate and tetrapropyl titanate; organotin compounds such as dibutyltin dilaurate, dibutyltin maleate, and dibutyltin diacetate; tin carboxylates such as tin octylate, tin naphthenate, tin laurate, and tin versatate; reaction products of dibutyltin oxide with phthalate ester; dibutyltin diacetylacetonate; organic aluminum compounds such as aluminum triacetylacetonate, aluminum trisethylacetoacetate, diisopropoxy aluminum ethylacetoacetate; chelate compounds such as diisopropoxy-bis(ethyl acetoacetate)titanium, zirconium tetraacetylacetonate, and titanium tetraacetylacetonate; lead octylates; iron naphthenates; bismuth compounds such as bismuth-tris(neodecanoate), bismuth-tris(2-ethylhexanoate); and the like. Further, known amine-based catalysts such as laurylamine may be used. Among them, tin carboxylates or organotin compounds such as dibutyltin dilaurate, dibutyltin maleate, dibutyltin diacetate, tin octylate, tin naphthenate, tin laurate, and tin versatate; reaction products of dibutyltin oxide with phthalate ester; tin-based catalysts such as dibutyltin diacetylacetonate; and chelate compounds such as diisopropoxy-bis(ethyl acetoacetate)titanium are particularly preferable.

### [Other Components]

The thermal conductive silicone composition of the present invention may contain organo(poly)siloxane having no reactivity, such as methylpolysiloxane, for the purpose of adjusting the elastic modulus and the viscosity. In addition, in order to prevent deterioration of the thermal conductive silicone composition, a known antioxidant such as 2,6-di-t-butyl-4-methylphenol may be added as necessary. Further, a dye, a pigment, a flame retardant, an antisettling agent, a thixotropy improver, or the like can be added as necessary.

### [Thermal Conductivity]

The thermal conductivity of the thermal conductive silicone composition of the present invention determined by a hot disc method in accordance with ISO 22007-2 is preferably 7.5 W/m·K or more. The upper limit of the thermal conductivity is not limited, however, it is preferably 13.0 W/m·K or less. The method for measuring the thermal conductivity is the method in the Examples described below.

Since the thermal conductive silicone composition of the present invention has a shift resistance, it is an optimum thermal conductive silicone composition. The method for measuring the shift resistance is as described in the Examples below.

### [Method for Producing Thermal Conductive Silicone Composition]

The method for producing the thermal conductive silicone composition of the present invention is described below; however, the production of the thermal conductive silicone composition of the present invention is not limited to these methods.

The production of the thermal conductive silicone composition of the present invention may be performed in accordance with the methods for producing previously-known thermal conductive silicone compositions, and is not particularly limited. For example, the thermal conductive silicone composition of the present invention may be obtained by mixing the components (A) to (J) described above, and, as necessary, other optional components. The mixing device is not particularly limited, and various mixers such as Trimix, Twinmix, Planetary Mixer (all registered trademarks of Inoue MFG., Inc.), Ultramixer (registered trademark of Mizuho Industrial Co., Ltd.) or Hivis Disper Mix (registered trademark of Tokushu Kika Kogyo Co., Ltd.), and the like may be used. In addition, a three-roll finishing process or the like may be performed to break up the aggregation of the component (C), and the components (D) and (E), which are heat conductive fillers.

In the thermal conductive silicone composition of the present invention, when the component (A) is an organopolysiloxane having one or more aliphatic unsaturated hydrocarbon groups bonded to a silicon atom within one molecule, and when using the components (F) and (G), it is preferable to agitate them at 100°C or higher for 30 minutes or longer, so that the components (A) and (F) are sufficiently cross-linked by a hydrosilylation reaction, thereby producing a thermal conductive silicone composition having more appropriate viscosity.

### EXAMPLES

The present invention is more specifically described below with reference to Examples and Comparative Examples. However, the present invention is not limited to these Examples. In the following, the kinematic viscosity is a value measured at 25°C by an Ostwald viscometer (manufactured by Sibata Scientific Technology Ltd.). The thickness of the pressurized component (C) is a value obtained by sandwiching a paste (thickness = 300 µm), which is prepared by mixing 150 parts by mass of the component (C) and 100 parts by mass of dimethylpolysiloxane having a kinematic viscosity at 25°C of 1,000 mm²/s, with two circular aluminum plates having a diameter of 12.6 mm and a thickness of 1 mm, followed by pressurization at 25°C and 0.1 MPa for 60 minutes, and measuring the resulting thickness using a micrometer (manufactured by Mitutoyo Corporation) while subtracting the thickness of the aluminum plates.

The components used herein are as follows.

### [Component (A)]

A-1: Dimethylpolysiloxane with both terminals blocked with trimethylsilyl groups, having a kinematic viscosity at 25°C of 5,000 mm²/s
A-2: Dimethylpolysiloxane with both terminals blocked with dimethylvinylsilyl groups, having a kinematic viscosity at 25°C of 600 mm²/s (amount of vinyl group = 0.015 mol/g)
A-3: Dimethylpolysiloxane with both terminals respectively blocked with a dimethylvinylsilyl group and a trimethylsilyl group, having a kinematic viscosity at 25°C of 700 mm²/s (amount of vinyl group = 0.005 mol/g)

### [Component (B)]

B-1: Hydrolysable organopolysiloxane represented by the formula below

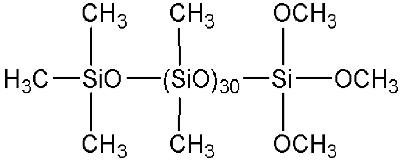

### [Component (C)]

C-1: Round aluminum nitride particle with D50 of 20.0 µm (thickness after the pressurization = 54 µm)
C-2: Round aluminum nitride particle with D50 of 11.0 µm (thickness after the pressurization = 32 µm)
C-3: Round aluminum nitride particle with D50 of 5.0 µm (thickness after the pressurization = 14 µm)
C-4: Spherical alumina particle with D50 of 10.0 µm (thickness after the pressurization = 25 µm) (component for comparison)

### [Component (D)]

D-1: Round aluminum nitride particle with D50 of 70.0 µm
D-2: Round aluminum nitride particle with D50 of 100.0 µm
D-3: Round aluminum nitride particle with D50 of 120.0 µm
D-4: Spherical aluminum nitride particle with D50 of 60.0 µm (component for comparison)
D-5: Spherical alumina particle with D50 of 100.0 µm (component for comparison)

### [Component (E)]

E-1: Irregular-shaped zinc oxide particle with D50 of 1.2 µm
E-2: Irregular-shaped zinc oxide particle with D50 of 0.4 µm
E-3: Round aluminum nitride particle with D50 of 0.7 µm
E-4: Irregular-shaped alumina particle with D50 of 1.3 µm

### [Component (F)]

F-1: Organohydrogenpolysiloxane with both terminals blocked with trimethylsilyl groups, having a kinematic viscosity at 25°C of 100 mm²/s and SiH content of 0.0055 mol/g

### [Component (G)]

G-1: Solution of platinum-divinyltetramethyldisiloxane complex dissolved in the same dimethylpolysiloxane as the above A-2 (platinum atom content: 1 mass%)

### [Component (H)]

H-1: Ethynylcyclohexanol

### [Examples 1-14, Comparative Examples 1-5]

### <Preparation of Thermal Conductive Silicone Composition>

Thermal conductive silicone compositions were prepared by blending the components (A) to (H) described above according to the formulations shown in Tables 1 to 3 below using the method described below.

The components (A) to (H) were placed in a 5-liter Planetary Mixer (manufactured by Inoue MFG., Inc.) and mixed at 150°C for 4 hours. The mixture was then cooled to 25°C to prepare a thermal conductive silicone composition. The viscosity, thermal conductivity, and shift resistance of each composition obtained by the above method were evaluated according to the following methods. Tables 1 to 3 show the results.

### [Viscosity]

The viscosity of the thermal conductive silicone composition was measured using a spiral viscometer (Type PC-1T: manufactured by Malcom corporation) at 25°C (10 rpm (Rotor A), shear rate = 6[1/s].)

### [Thermal Conductivity]

Each composition was wrapped with kitchen wrap into a drawstring-pouch-like form, and the thermal conductivity of the composition in this form was measured using TPA-501 manufactured by Kyoto Electronics Industry Co.,Ltd.

### [Shift Resistance]

A test piece was prepared by sandwiching 1.0 g of the composition between a 60 mm × 60 mm aluminum plate and glass plate using a spacer so that the thickness was 0.5 mm. After the test piece was allowed to stand vertically at 25°C for 12 hours, composition(s) that had shifted were evaluated as "Bad" and composition(s) that had not shifted were evaluated as "Good". Further, the test piece was placed vertically in a thermal test machine that is operated with 1 cycle of -40°C for 30 minutes and 120°C for 30 minutes, and the composition that had not shifted after 1,000 cycles was evaluated as "Excellent".

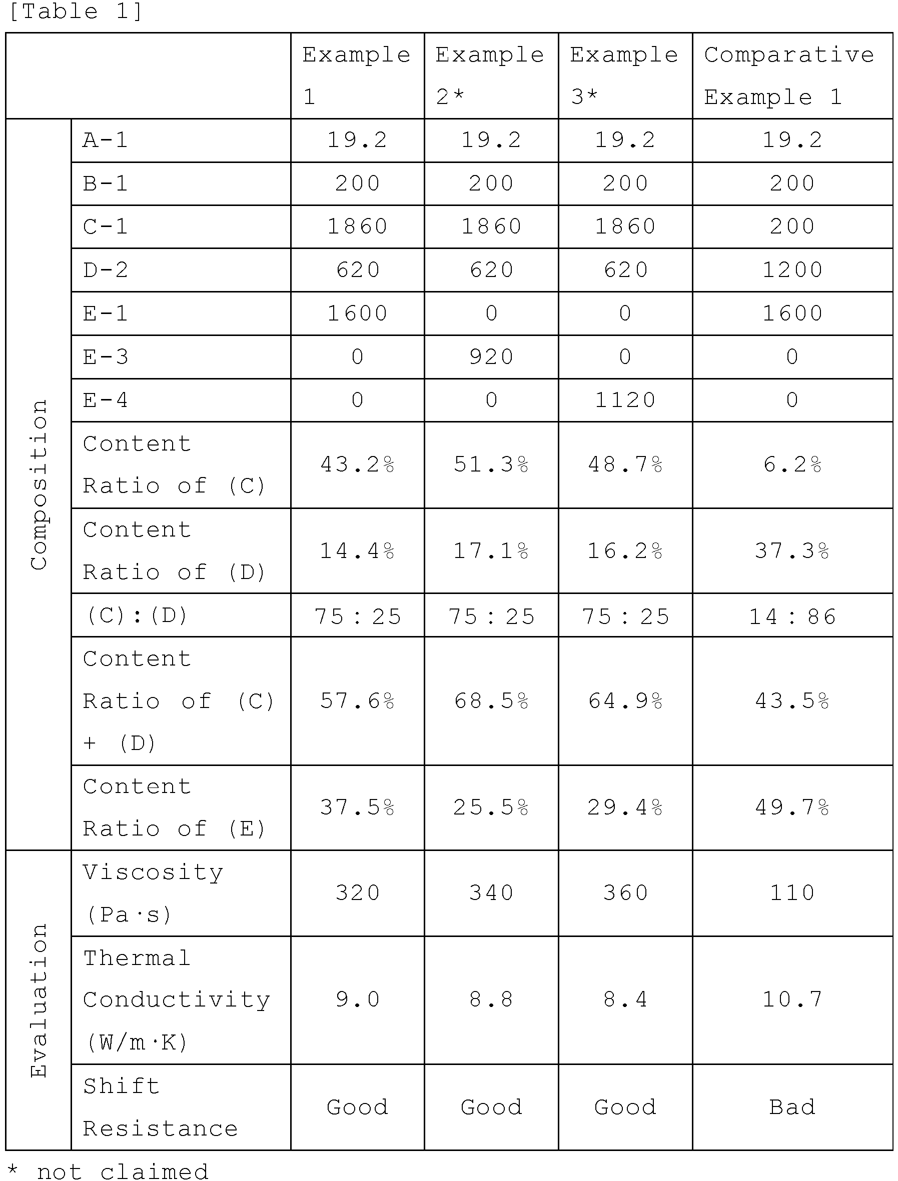

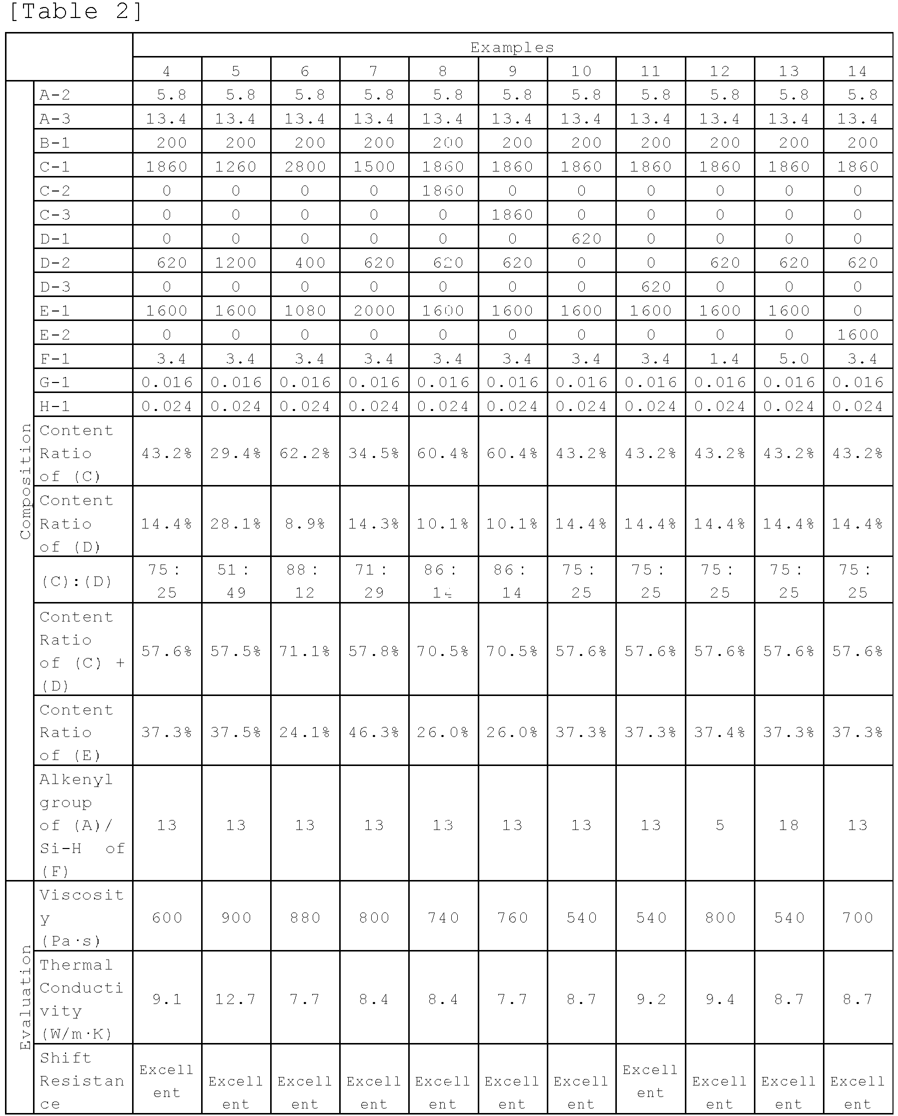

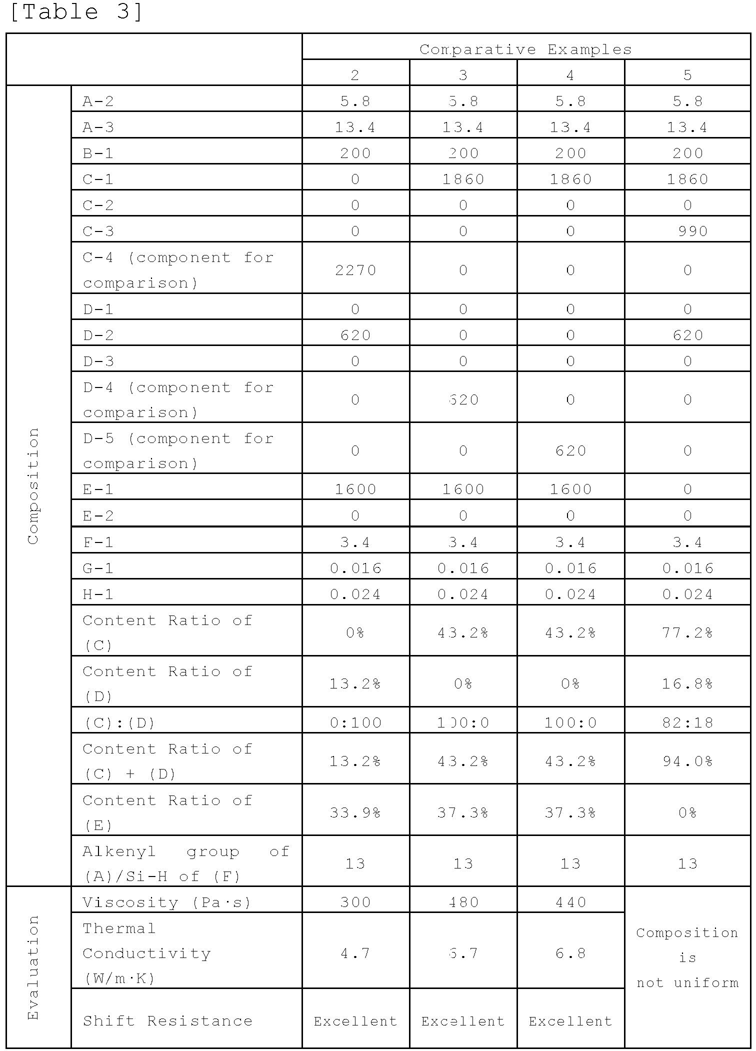

The results shown in Tables 1 to 3 revealed that the thermal conductive silicone compositions of Examples 1 to 14 that meet the requirements of the present invention (except for Examples 2 and 3) can ensure both high thermal conduction property and shift resistance against thermal shock.

In contrast, Comparative Example 1 in which the ratio of the component (D) relative to the total amount of the component (C) and the component (D) is 50 mass% or more had inferior shift resistance. Furthermore, in Comparative Example 2 using spherical particles instead of the component (C) of the present invention and Comparative Examples 3 and 4 using spherical particles instead of the component (D) of the present invention, the thermal conduction property was inferior. In Comparative Example 5 that does not contain the component (E) of the present invention, the composition was not uniform, and the handleability was significantly inferior.

## Claims

1. A thermal conductive silicone composition comprising:
(C) one or more aluminum nitride particles selected from an irregular-shaped, a round, and a polyhedral particles having an average particle size of 4 µm or more and 30 µm or less;
(D) one ore more aluminum nitride particles selected from an irregular-shaped, a round, and a polyhedral particles having an average particle size of 60 µm or more and 150 µm or less; and
(E) an irregular-shaped zinc oxide_particle having an average particle size of 0.1 µm or more and less than 4.0 µm; wherein
a total amount of the component (C) and the component (D) is 20 mass% or more and less than 80 mass% in the entire composition, and
an amount of the component (E) is 20 mass% or more and less than 50 mass% in the entire composition, a ratio of the component (D) relative to the total amount of the component (C) and the component (D) is 5 mass% or more and less than 50 mass%,_
wherein the term "round particles" means that the particles have less corners and are rounded and smooth, and a spherical shape is not included.

2. The thermal conductive silicone composition according to claim 1, wherein
the component (C) are round aluminum nitride particles.

3. The thermal conductive silicone composition according to claim 1 or 2, wherein
when a paste of the component (C) with a thickness of 300 µm prepared by mixing 150 parts by mass of the component (C) and 100 parts by mass of a dimethylpolysiloxane having a kinematic viscosity at 25°C of 1,000 mm²/s is pressurized at 25°C and 0.1 MPa for 60 minutes, the thickness of the pressurized silicone composition is 10 µm or more and 100 µm or less.

4. The thermal conductive silicone composition according to any one of claims 1 to 3, further comprising (A) an organopolysiloxane having a kinematic viscosity at 25°C of 10 to 100,000 mm²/s.

5. The thermal conductive silicone composition according to claim 4, wherein
the component (A) is an organopolysiloxane having one or more aliphatic unsaturated hydrocarbon groups bonded to a silicon atom within one molecule.

6. The thermal conductive silicone composition according to claim 5, further comprising
(F) an organohydrogenpolysiloxane having two or more hydrogen atoms bonded to a silicon atom within one molecule,
(G) a platinum group metal catalyst, and
(H) a reaction inhibitor.

7. The thermal conductive silicone composition according to claim 6, comprising a hydrosilylation reaction product of the component (A) and the component (F).

8. The thermal conductive silicone composition according to claim 6 or 7, wherein
a number of the hydrogen atom bonded to a silicon atom within one molecule in the component (F) is 4.0 to 20.0 relative to one aliphatic unsaturated hydrocarbon group bonded to a silicon atom within one molecule in the component (A).

9. The thermal conductive silicone composition according to any one of claims 5 to 8, further comprising (I) an organic peroxide.

10. The thermal conductive silicone composition according to any one of claims 1 to 9, further comprising (B) a hydrolysable organopolysiloxane containing an alkoxysilyl group.

11. The thermal conductive silicone composition according to claim 10, further comprising (J) a condensation catalyst.

## Patentansprüche

1. Wärmeleitende Silikonzusammensetzung, umfassend:
(C) ein oder mehrere Aluminiumnitridpartikel, ausgewählt aus unregelmäßig geformten, runden und polyedrischen Partikeln mit einer durchschnittlichen Partikelgröße von 4 µm oder mehr und 30 µm oder weniger;
(D) ein oder mehrere Aluminiumnitridpartikel, ausgewählt aus unregelmäßig geformten, runden und polyedrischen Partikeln mit einer durchschnittlichen Partikelgröße von 60 µm oder mehr und 150 µm oder weniger; und
(E) ein unregelmäßig geformtes Zinkoxidpartikel mit einer durchschnittlichen Partikelgröße von 0,1 µm oder mehr und weniger als 4,0 µm; wobei
eine Gesamtmenge der Komponente (C) und der Komponente (D) 20 Massenprozent oder mehr und weniger als 80 Massenprozent in der gesamten Zusammensetzung beträgt und
eine Menge der Komponente (E) 20 Massenprozent oder mehr und weniger als 50 Massenprozent in der gesamten Zusammensetzung beträgt, ein Verhältnis der Komponente (D) zur Gesamtmenge der Komponente (C) und der Komponente (D) 5 Massenprozent oder mehr und weniger als 50 Massenprozent beträgt,
wobei der Begriff "runde Partikel" bedeutet, dass die Partikel weniger Ecken haben und abgerundet und glatt sind, und eine kugelförmige Form nicht enthalten ist.

2. Wärmeleitfähige Silikonzusammensetzung nach Anspruch 1, wobei
die Komponente (C) runde Aluminiumnitridpartikel sind.

3. Wärmeleitfähige Silikonzusammensetzung nach Anspruch 1 oder 2, wobei
wenn eine Paste der Komponente (C) mit einer Dicke von 300 µm, hergestellt durch Mischen von 150 Masseteilen der Komponente (C) und 100 Masseteilen eines Dimethylpolysiloxans mit einer kinematischen Viskosität bei 25 °C von 1.000 mm²/s, bei 25 °C und 0,1 MPa für 60 Minuten unter Druck gesetzt wird, die Dicke der unter Druck gesetzten Silikonzusammensetzung 10 µm oder mehr und 100 µm oder weniger beträgt.

4. Wärmeleitfähige Silikonzusammensetzung nach einem der Ansprüche 1 bis 3, ferner umfassend (A) ein Organopolysiloxan mit einer kinematischen Viskosität bei 25 °C von 10 bis 100.000 mm²/s.

5. Wärmeleitfähige Silikonzusammensetzung nach Anspruch 4, wobei
die Komponente (A) ein Organopolysiloxan mit einer oder mehreren aliphatischen ungesättigten Kohlenwasserstoffgruppen ist, die an ein Siliciumatom innerhalb eines Moleküls gebunden sind.

6. Wärmeleitfähige Silikonzusammensetzung nach Anspruch 5, ferner umfassend
(F) ein Organohydrogenpolysiloxan mit zwei oder mehr Wasserstoffatomen, die an ein Siliciumatom innerhalb eines Moleküls gebunden sind,
(G) einen Katalysator aus einem Metall der Platingruppe und
(H) einen Reaktionsinhibitor.

7. Wärmeleitfähige Silikonzusammensetzung nach Anspruch 6, umfassend ein Hydrosilylierungsreaktionsprodukt der Komponente (A) und der Komponente (F).

8. Wärmeleitfähige Silikonzusammensetzung nach Anspruch 6 oder 7, wobei
eine Anzahl der an ein Siliciumatom innerhalb eines Moleküls in der Komponente (F) gebundenen Wasserstoffatome 4,0 bis 20,0 beträgt, bezogen auf eine an ein Siliciumatom innerhalb eines Moleküls in der Komponente (A) gebundene aliphatische ungesättigte Kohlenwasserstoffgruppe.

9. Wärmeleitfähige Silikonzusammensetzung nach einem der Ansprüche 5 bis 8, ferner umfassend (I) ein organisches Peroxid.

10. Wärmeleitfähige Silikonzusammensetzung nach einem der Ansprüche 1 bis 9, ferner umfassend (B) ein hydrolysierbares Organopolysiloxan, das eine Alkoxysilylgruppe enthält.

11. Wärmeleitfähige Silikonzusammensetzung nach Anspruch 10, ferner umfassend (J) einen Kondensationskatalysator.

## Revendications

1. Composition de silicone thermoconductrice comprenant:
(C) une ou plusieurs particules de nitrure d'aluminium choisies parmi des particules de forme irrégulière, rondes et polyédriques ayant une dimension granulométrique moyenne comprise supérieure ou égale à 4 µm ou inférieure ou égale à 30 µm;
(D) une ou plusieurs particules de nitrure d'aluminium choisies parmi des particules de forme irrégulière, rondes et polyédriques ayant une dimension granulométrique moyenne comprise supérieure ou égale à 60 µm ou inférieure à égale à 150 µm ; et
(E) une particule d'oxyde de zinc de forme irrégulière ayant une dimension moyenne granulométrique supérieure ou égale à 0,1 µm et inférieure à 4,0 µm ; dans laquelle
la quantité totale du composant (C) et du composant (D) est supérieure ou égale à 20 % et inférieure à 80 % en masse dans la composition totale, et
la quantité du composant (E) est supérieure ou égale à 20 % et inférieure à 50 % en masse dans la composition totale, le rapport entre le composant (D) et la quantité totale du composant (C) et du composant (D) est supérieur ou égale à 5 % et inférieur à 50 % en masse,_
dans laquelle le terme « particules rondes » signifie que les particules comptent moins de coins et sont arrondies et lisses, et qu'une forme sphérique n'est pas incluse.

2. Composition de silicone thermoconductrice selon la revendication 1, dans laquelle
le composant (C) est constitué de particules rondes de nitrure d'aluminium.

3. Composition de silicone thermoconductrice selon la revendication 1 ou 2, dans laquelle
lorsqu'une pâte du composant (C) d'une épaisseur de 300 µm préparée par mélange de 150 parties en masse du composant (C) et de 100 parties en masse d'un diméthylpolysiloxane dont la viscosité cinématique à 25 °C s'élève à 1 000 mm²/s est mise sous pression à 25 °C et 0,1 MPa pendant 60 minutes, l'épaisseur de la composition de silicone mise sous pression est supérieure ou égale à 10 µm et inférieure ou égale à 100 µm.

4. Composition de silicone thermoconductrice selon l'une quelconque des revendications 1 à 3, comprenant en outre (A) un organopolysiloxane dont la viscosité cinématique à 25 °C est comprise entre 10 et 100 000 mm²/s.

5. Composition de silicone thermoconductrice selon la revendication 4, dans laquelle
le composant (A) est un organopolysiloxane comportant un ou plusieurs groupes hydrocarbure aliphatique insaturé liés à un atome de silicium à l'intérieur d'une molécule.

6. Composition de silicone thermoconductrice selon la revendication 5, comprenant en outre
(F) un organohydrogénopolysiloxane comportant deux atomes d'hydrogène ou plus liés à un atome de silicium à l'intérieur d'une molécule,
(G) un catalyseur à base d'un métal du groupe platine, et
(H) un inhibiteur de réaction.

7. Composition de silicone thermoconductrice selon la revendication 6, comprenant un produit de réaction d'hydrosilylation du composant (A) et du composant (F).

8. Composition de silicone thermoconductrice selon la revendication 6 ou 7, dans laquelle
le nombre d'atomes d'hydrogène liés à un atome de silicium à l'intérieur d'une molécule du composant (F) est compris entre 4,0 et 20,0 par rapport à un groupe hydrocarbure aliphatique insaturé lié à un atome de silicium à l'intérieur d'une molécule du composant (A).

9. Composition de silicone thermoconductrice selon l'une quelconque des revendications 5 à 8, comprenant en outre (I) un peroxyde organique.

10. Composition de silicone thermoconductrice selon l'une quelconque des revendications 1 à 9, comprenant en outre B) un organopolysiloxane hydrolysable contenant un groupe alcoxysilyle.

11. Composition de silicone thermoconductrice selon la revendication 10, comprenant en outre (J) un catalyseur de condensation.
